# FASCICULE DE BREVET EUROPEEN

(11) **EP 3 331 017 B1**
(45) Date de publication et mention de la délivrance du brevet: **23.11.2022**
(21) Numéro de dépôt: 17204851.4
(22) Date de dépôt: 01.12.2017
(51) Int. Cl.: H01L 27/30, H01L 51/42

(54) **PHOTODÉTECTEUR INFRAROUGE**
INFRAROT-FOTOSENSOR
INFRARED PHOTODETECTOR

(30) Priorité: 05.12.2016 FR 1661919
(43) Date de publication de la demande: 06.06.2018
(73) Titulaire: Commissariat à l'Energie Atomique et aux Energies Alternatives, 75015 Paris (FR); ISORG, 87068 Limoges Cedex 3 (FR)
(72) Inventeur: PEREIRA, Alexandre, 38950 SAINT-MARTIN-LE-VINOUX (FR); DUCROS, Cédric, 38690 BEVENAIS (FR); SCHWARTZ, Wilfrid, 38000 GRENOBLE (FR)
(74) Mandataire: Cabinet Beaumont

(56) Documents cités:
- US-A1- 2010 044 569
- WANG J B ET AL: "High speed responsive near infrared photodetector focusing on 808nm radiation using hexadecafluoro-copper-phthalocyanine as the acceptor", ORGANIC ELECTRONICS, ELSEVIER, AMSTERDAM, NL, vol. 12, no. 1, 1 janvier 2011 (2011-01-01), pages 34-38, XP027576983, ISSN: 1566-1199 [extrait le 2010-12-27]
- BINDA M ET AL: "Fast and air stable near-infrared organic detector based on squaraine dyes", ORGANIC ELECTRONICS, ELSEVIER, AMSTERDAM, NL, vol. 10, no. 7, 1 novembre 2009 (2009-11-01), pages 1314-1319, XP026574380, ISSN: 1566-1199, DOI: 10.1016/J.ORGEL.2009.07.011 [extrait le 2009-07-17]

## Description

### Domaine

La présente demande concerne un photodétecteur infrarouge et son procédé de fabrication.

### Exposé de l'art antérieur

Un dispositif de détection d'un rayonnement électromagnétique, ou photodétecteur, permet de convertir le rayonnement électromagnétique en un signal électrique. On a déjà proposé de réaliser des photodétecteurs à base de matériaux conducteurs et semiconducteurs organiques. La zone active du photodétecteur est la zone dans laquelle la majorité du rayonnement incident est absorbée et convertie en signal électrique. Un photodétecteur dont la zone active est réalisée en matériaux organiques est appelée photodétecteur organique. Les matériaux organiques présentent l'avantage d'être plus faciles à déposer et moins fragiles que les matériaux conducteurs et semiconducteurs inorganiques, par exemple le silicium, utilisés dans les filières technologiques traditionnelles.

L'utilisation de matériaux organiques permet, de façon avantageuse, de réaliser le photodétecteur sur tous types de substrats et en particulier sur des substrats souples tels que du plastique, du papier, du carton ou du tissu, sur des substrats de grandes dimensions, par exemple des panneaux publicitaires, ou sur des substrats jetables tels que des emballages de produits de consommation courante.

Les matériaux semiconducteurs composant le photodétecteur peuvent être choisis pour permettre la détection d'un rayonnement infrarouge. Le photodétecteur est par exemple associé à une diode électroluminescente infrarouge et permet la détection du rayonnement infrarouge émis par la diode électroluminescente.

Toutefois, pour les matériaux semiconducteurs organiques utilisables pour la détection d'un rayonnement infrarouge, la plage de fréquences du rayonnement absorbé par la zone active du photodétecteur est généralement plus large que la bande de fréquences correspondant à un rayonnement infrarouge de sorte que le signal électrique fourni par le photodétecteur peut être pollué par la détection d'un rayonnement parasite, notamment la lumière visible ambiante, en dehors de la plage de fréquences d'intérêt.

Il peut être nécessaire d'associer un filtre optique au photodétecteur qui est au moins partiellement opaque au rayonnement de fréquences situées en dehors de la plage de fréquences d'intérêt pour réduire les effets du rayonnement parasite, notamment de la lumière visible. Pour réduire l'encombrement du photodétecteur, il serait souhaitable de pouvoir réaliser le filtre optique de façon intégrée avec le photodétecteur. La demande de brevet EP1432044 décrit la formation d'un filtre optique comprenant le dépôt d'une couche de silicium polycristallin sur un photodétecteur. Toutefois, un tel dépôt est réalisé à une température supérieure à 400°C et ne peut pas être mis en oeuvre avec un photodétecteur organique, comprenant notamment un substrat en plastique.

La publication de Wang et al intitulée "High speed responsive near infrared photodetector focusing on 808nm radiation using hexadecafluoro-copper-phthalocyanine as the acceptor" (Organic Electronics, Elsevier, Amsterdam, NL, vol. 12, no. 1, 1 janvier 2011, pages 34-38), le document US 2010/044569, et la publication de Binda et al intitulée "Fast and air stable near-infrared organic detector based on squaraine dyes" (Organic Electronics, Elsevier, Amsterdam, NL, vol. 10, no. 7, 1 novembre 2009, pages 1314-1319) décrivent chacun des photodétecteurs infrarouges.

### Résumé

Un objet d'un mode de réalisation est de pallier tout ou partie des inconvénients des photodétecteurs infrarouges décrits précédemment.

Un autre objet d'un mode de réalisation est de pouvoir réaliser un filtre optique de façon intégrée à un photodétecteur organique.

Un autre objet d'un mode de réalisation est que le photodétecteur est réalisé sur un substrat souple.

Un autre objet d'un mode de réalisation est de pouvoir réaliser un filtre optique pour photodétecteur organique de façon simple.

Un autre objet d'un mode de réalisation est de pouvoir réaliser un filtre optique pour photodétecteur organique à une température réduite.

Ainsi, un mode de réalisation prévoit un photodétecteur infrarouge comprenant un empilement de couches sur un substrat dont une zone active en matériaux semiconducteurs organiques adaptée à convertir un rayonnement infrarouge en un signal électrique et comprenant, dans ledit empilement et/ou sur le substrat, une seule couche de filtrage au moins partiel de la lumière visible, dans lequel la couche de filtrage comprend un matériau choisi parmi le groupe comprenant le silicium amorphe, les alliages de silicium et de germanium amorphe, les alliages de cuivre, d'indium, de gallium et de sélénium, le sulfure de cuivre, zinc et étain ou un mélange d'au moins deux de ces composés.

Selon un mode de réalisation, l'épaisseur de la couche de filtrage est comprise entre 50 nm et 150 nm.

Selon un mode de réalisation, le substrat est flexible.

Selon un mode de réalisation, le substrat est choisi parmi le groupe comprenant le polyéthylène naphtalène, le polyéthylène téréphtalate, le poly(méthacrylate de méthyle), le polycarbonate, le polyétheréthercétone ou un polyimide.

Un mode de réalisation prévoit également un système optoélectronique comprenant un photodétecteur infrarouge tel que défini précédemment et une source d'un rayonnement infrarouge.

Selon un mode de réalisation, le procédé de fabrication du photodétecteur selon la revendication 1 comprend la fabrication de la couche de filtrage à une température inférieure à 200°C.

Selon un mode de réalisation, la couche de filtrage est déposée par pulvérisation cathodique, par évaporation par faisceau d'électron en phase vapeur, par pulvérisation par faisceau d'ion, ou par évaporation thermique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 4 sont des vue en coupe, partielles et schématiques, de modes de réalisation d'un photodétecteur organique infrarouge ;
la figure 5 est une vue schématique d'un système optoélectronique comprenant un photodétecteur infrarouge ;
la figure 6 représente des courbes d'évolution de constantes optiques du silicium amorphe en fonction de la longueur d'onde ;
la figure 7 représente des courbes d'évolution de la transmission d'un rayonnement électromagnétique monochromatique traversant une couche de silicium amorphe en fonction de la longueur d'onde du rayonnement pour plusieurs épaisseurs de la couche ;
la figure 8 représente des courbes d'évolution de l'irradiance d'une source de lumière blanche et d'une source infrarouge en l'absence et en présence d'une couche de silicium amorphe ;
la figure 9 est une figure analogue à la figure 8 dans le cas où la lumière blanche est remplacée par la lumière du soleil ;
la figure 10 représente des courbes d'évolution de la sensibilité d'un photodétecteur en l'absence de filtre optique pour différentes densités de puissance lumineuse d'un rayonnement incident ;
la figure 11 représente une courbe d'évolution de l'efficacité quantique externe d'un photodétecteur test et d'un photodétecteur de comparaison ;
la figure 12 représente des courbes d'évolution du courant fourni en présence seulement d'une LED infrarouge et en présence de la LED infrarouge et d'une LED blanche d'un photodétecteur test et d'un photodétecteur de comparaison ;
la figure 13 représente des courbes d'évolution de la partie du courant due à la LED blanche pour les courbes de la figure 12 ;
la figure 14 représente des courbes d'évolution du ratio entre le courant fourni par un photodétecteur en présence seulement d'une LED infrarouge et le courant fourni par le photodétecteur en présence de la LED infrarouge et d'une LED blanche pour un photodétecteur test et un photodétecteur de comparaison ; et
la figure 15 représente des courbes d'évolution du rapport signal sur bruit entre le courant fourni par le photodétecteur en présence seulement d'une LED infrarouge et en présence de la LED infrarouge et d'une LED blanche pour un photodétecteur test et un photodétecteur de comparaison.

### Description détaillée

Par souci de clarté, de mêmes éléments ont été désignés par de mêmes références aux différentes figures et, de plus, les diverses figures ne sont pas tracées à l'échelle. En outre, seuls les éléments utiles à la compréhension des modes de réalisation ont été représentés et sont décrits. En particulier, les moyens de traitement des signaux fournis par les photodétecteurs décrits ci-après sont à la portée de l'homme de l'art et ne sont pas décrits. Dans la suite de la description, sauf indication contraire, les termes "sensiblement", "environ" et "de l'ordre de" signifient "à 10 % près".

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,4 µm.

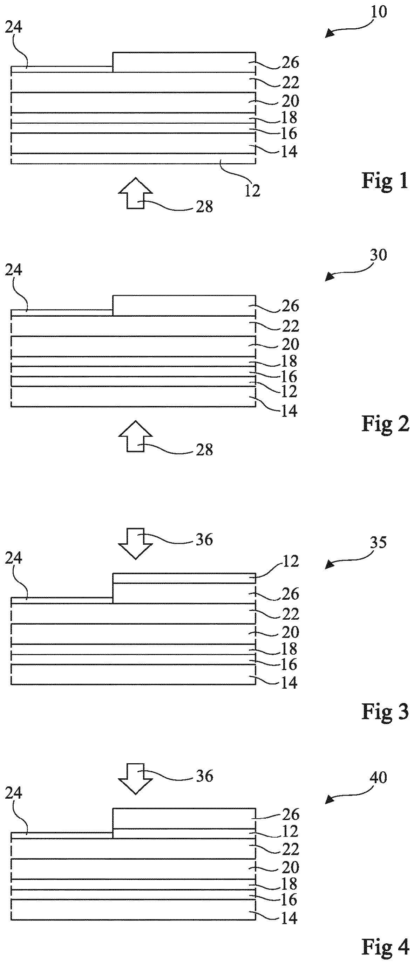

La figure 1 représente un mode de réalisation d'un photodétecteur organique infrarouge 10. Le photodétecteur 10 comprend de bas en haut :
une couche 12 formant un filtre optique ;
un premier substrat 14 ;
une couche 16 conductrice électriquement formant une première électrode ;
une première couche d'interface 18 ;
une zone active 20 ;
une deuxième couche d'interface 22 ;
une couche 24 conductrice électriquement formant une deuxième électrode ; et
un deuxième substrat 26.

Dans le présent mode de réalisation, le photodétecteur 10 est destiné à être éclairé du côté du filtre optique 12 par un rayonnement incident représenté par la flèche 28, comprenant notamment un rayonnement infrarouge.

En figure 1, l'électrode 24 et le substrat 26 sont représentés l'un à côté de l'autre et reposant sur la couche d'interface 22. A titre de variante, l'électrode 24 peut recouvrir la totalité de la couche d'interface 22 et le substrat 26 peut recouvrir la totalité de l'électrode 24.

A titre de variante, la première couche d'interface 18 ou la deuxième couche d'interface 22 peuvent ne pas être présentes. En outre, seul l'un des deux substrats 14, 26 peut être présent ou l'un des deux substrats 14, 26 peut être remplacé par une couche de protection.

Le substrat 14 ou 26 peut être en un matériau diélectrique. Le substrat 14 ou 26 est de préférence un support flexible. La flexibilité d'un matériau peut être définie par le rayon de courbure minimum que l'on peut appliquer au matériau au-delà duquel le matériau peut retrouver sa forme initiale. Dans la présente description, on entend par support flexible un support pour lequel le rayon de courbure minimum que l'on peut appliquer au support au-delà duquel le support peut retrouver sa forme initiale est de 1 mm. Des exemples de polymère sont le polyéthylène naphtalène (PEN), le polyéthylène téréphtalate (PET), le poly(méthacrylate de méthyle) (PMMA), le polycarbonate (PC), le polyétheréthercétone (PEEK) ou un polyimide, notamment le kapton. L'épaisseur du substrat 14 ou 26 est, par exemple, comprise entre 20 µm et 1 cm. Dans le présent mode de réalisation, le substrat 14 est au moins partiellement transparent au rayonnement infrarouge.

Chaque électrode 16 ou 24 peut être réalisée en un oxyde conducteur transparent au rayonnement infrarouge (TCO, de l'anglais Transparent Conducting Oxide), en nanotubes de carbone, en graphène, en un polymère conducteur, en un métal ou en un mélange ou un alliage d'au moins deux de ces composés. L'électrode 16 ou 24 peut avoir une structure monocouche ou une structure multicouche. L'épaisseur de l'électrode 16 ou 24 est comprise entre 5 nm et 200 nm. Dans le présent mode de réalisation, l'électrode 16 est destinée à être traversée par le rayonnement 28. Elle est réalisée en un matériau conducteur électriquement au moins partiellement transparent au rayonnement infrarouge.

Des exemples de TCO adaptés à la réalisation de l'électrode 24 sont l'oxyde d'indium-étain (ITO, de l'anglais Indium Tin Oxide), l'oxyde d'aluminium-zinc (AZO, de l'anglais Aluminium Zinc Oxide) et l'oxyde de gallium-zinc (GZO, de l'anglais Gallium Zinc Oxide). Des exemples de polymères conducteurs adaptés à la réalisation des électrodes sont le polymère connu sous la dénomination PEDOT:PSS, qui est un mélange de poly(3,4)-éthylènedioxythiophène et de polystyrène sulfonate de sodium ou la polyaniline, également appelé PAni. Des exemples de métaux adaptés à la réalisation des électrodes sont l'argent (Ag), l'or (Au), le cuivre (Cu), le nickel (Ni), le titane (Ti) et le chrome (Cr). Un exemple de structure multicouche adaptée à la réalisation des électrodes est une structure multicouche d'AZO et d'argent de type AZO/Ag/AZO. L'épaisseur de l'électrode peut être comprise entre 10 nm et 5 µm. Dans le cas où l'électrode 24 est métallique et doit être au moins partiellement transparente au rayonnement infrarouge, l'épaisseur de l'électrode est inférieure ou égale à 20 nm, de préférence inférieure ou égale à 10 nm. Elle peut correspondre alors à des fils nanométriques en argent.

La zone active 20 peut comprendre des petites molécules organiques, des oligomères organiques ou des polymères organiques. La zone active 20 peut comprendre un matériau semiconducteur ambipolaire, ou un mélange d'un matériau semiconducteur de type N et d'un matériau semiconducteur de type P, par exemple sous forme de couches superposées ou de mélange intime à l'échelle nanométrique de façon à former une hétérojonction en volume. L'épaisseur de la zone active 20 peut être comprise entre 50 nm et 1 µm, par exemple de l'ordre de 500 nm.

Des exemples de matériaux organiques semiconducteurs de type P adaptés à la réalisation de la zone active 20 sont le poly[(4,8-bis-(2-éthylhexyloxy)-benzo[1,2-b;4,5-b']dithiophène)-2,6-diyl-alt-(4-(2-éthylhexanoyl)-thie-no[3,4-b]thiophène))-2,6-diyl];4,5-b']dithi-ophène)-2,6-diyl-alt-(5,5'-bis(2-thiényl)-4,4,-dinonyl-2,2'-bithiazole)-5',5"-diyl] (PBDTTT-C), le poly[2,6-(4,4-bis-(2-éthylhexyl)-4*H*-cyclopenta [2,1-b;3,4-*b*']dithiophène)-*alt*-4,7(2,1,3-benzothiadiazole)] (PCPDTBT), le poly[2,7-(5,5-bis-(diméthyloctyl)-5H-dithiéno[3,2-b:20,30-d]pyran)-alt-4,7-(5,6-difluoro-2,1,3-benzothiadiazole)] (PDTP-DFBT), le squaraine (SQ), le polytéréphtalate de triméthylène (PTT), le poly(5,7-bis(4-décanyl-2-thiényl)thiéno[3,4- b ]diathiazole-thiophène-2,5) (PDDTT), ou le 2,5-bis(4-biphénylyl)-bithiophène / 2,5-bis(4-biphénylyl)- bithiophène (BP2T/TiOPc).

Des exemples de matériaux semiconducteurs de type N adaptés à la réalisation de la zone active 20 sont les fullerènes, notamment le C60, le [6,6]-phényl-C₆₁-butanoate de méthyle ([60]PCBM), le [6,61-phényl-C₇₁-butanoate de méthyle ([70]PCBM) ou le pérylène diimide (PDI).

La couche d'interface 18 permet d'aligner le travail de sortie de l'électrode 16 avec l'affinité électronique du matériau accepteur utilisé dans la zone active 20 et la couche d'interface 22 permet d'aligner le travail de sortie de l'électrode 24 avec le potentiel d'ionisation du matériau donneur utilisé dans la zone active 20. Suivant le mode de polarisation de la diode, les couches d'interface 18, 22 facilitent la collection, l'injection ou le blocage des charges depuis les électrodes 16, 24 dans la zone active 20. L'épaisseur de chaque couche d'interface 18, 22 est de préférence comprise entre 0,1 nm et 1 µm.

La couche d'interface 18 peut être réalisée en oxyde de zinc (ZnO), en carbonate de césium (CSCO₃) ou en un mélange d'au moins deux de ces composés. La couche d'interface 18 est de préférence réalisée en un oxyde métallique, plus préférentiellement en oxyde de zinc. La couche d'interface 18 peut comprendre une couche monomoléculaire auto-assemblée ou un polymère par exemple du polyéthyléneimine, polyéthyléneimine éthoxylé, ou du poly[(9,9-bis(3'-(N,N-dimethylamino)propyl)-2,7-fluorene)-alt-2,7-(9,9-dioctylfluorene)] (PFN).

La couche d'interface 22 peut être réalisée en oxyde de cuivre (CuO), en oxyde de nickel (NiO), en oxyde de vanadium (V₂O₅), en oxyde de magnésium (MgO), en oxyde de tungstène (WO₃), en trioxyde de molybdène (MoO₃), en PEDOT:PSS, ou en un mélange d'au moins deux de ces composés.

La couche 12 permet de filtrer le rayonnement incident 28 pour bloquer au moins partiellement les fréquences en dehors d'une plage de fréquences d'intérêt. Selon un mode de réalisation, la couche 12 transmet au moins 30 % du rayonnement incident 28 pour la plage de longueurs d'onde de 700 nm et 1,4 µm et transmet moins de 40 % du rayonnement incident 28 pour la plage de longueurs d'onde de 400 nm et 700 nm.

La couche 12 peut être en un matériau choisi parmi le groupe comprenant le silicium amorphe (aSi), les alliages de silicium et de germanium amorphe (aSiGe), les alliages de cuivre, d'indium, de gallium et de sélénium (CIGS), le sulfure de cuivre, zinc et étain (CZTS) ou un mélange d'au moins deux de ces composés. De préférence, la couche 12 a une structure monocouche. L'épaisseur de la couche 12 est comprise entre 50 nm et 150 nm, de préférence entre 70 nm et 120 nm.

La figure 2 représente un autre mode de réalisation d'un photodétecteur 30. Le photodétecteur 30 comprend l'ensemble des éléments du photodétecteur 10 représenté en figure 1 à la différence que le filtre optique 12 est interposé entre le substrat 14 et l'électrode 16.

La figure 3 représente un autre mode de réalisation d'un photodétecteur 35. Le photodétecteur 35 comprend l'ensemble des éléments du photodétecteur 10 représenté en figure 1 à la différence que le filtre optique 12 recouvre le substrat 26 et que le photodétecteur 35 est éclairé du côté du substrat 26 comme cela est indiqué par la flèche 36.

La figure 4 représente un autre mode de réalisation d'un photodétecteur 40. Le photodétecteur 40 comprend l'ensemble des éléments du photodétecteur 35 représenté en figure 3 à la différence que le filtre optique 12 est interposé entre le substrat 26 et la couche d'interface 22.

Un procédé de fabrication des photodétecteurs 10, 30, 35 et 40 décrits précédemment comprend la formation successive des couches composant le photodétecteur 10 sur le substrat 14, à savoir la couche 12 de filtrage optique, l'électrode 16, la couche d'interface 18, la zone active 20, la couche d'interface 22 et l'électrode 24. Le substrat 26 peut ensuite être collé sur la couche d'interface 22.

Selon le matériau utilisé pour l'électrode 16, la couche d'interface 18, la zone active 20, la couche d'interface 22 et l'électrode 24, le procédé de formation de la couche considérée peut correspondre à un procédé dit additif, par exemple par impression directe du matériau composant la couche considérée aux emplacements souhaités notamment sous forme de sol-gel, par exemple par impression par jet d'encre, héliographie, sérigraphie, flexographie, revêtement par pulvérisation (en anglais spray coating) ou dépôt de gouttes (en anglais drop-casting). Le procédé de formation de la couche considérée peut correspondre à un procédé dit soustractif, dans lequel le matériau composant la couche considérée est déposé sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Lorsque l'électrode 16 ou 24 est métallique, le métal est, par exemple, déposé par évaporation ou par pulvérisation cathodique sur la structure sous-jacente et l'électrode 16 ou 24 est délimitée par gravure.

La couche 12 formant le filtre optique est déposée par dépôt physique en phase vapeur (PVD, sigle anglais pour Physical Vapor Déposition), notamment par pulvérisation cathodique, en particulier par pulvérisation cathodique magnétron, par évaporation par faisceau d'électron en phase vapeur (PVD e-beam), par pulvérisation par faisceau d'ion (IBS, signal anglais pour Ion Beam Sputtering), ou par évaporation thermique. De préférence, la couche 12 est déposée par pulvérisation cathodique magnétron. Selon un mode de réalisation, la température de dépôt est inférieure à 200°C, de préférence inférieure à 150°C, plus préférentiellement inférieure à 100°C, notamment inférieure à 80°C.

De façon avantageuse, au moins certaines des couches du dispositif de détection 10 peuvent être réalisées par des techniques d'impression. Les matériaux des couches 16, 18, 20, 22 décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150°C, et le dépôt et les éventuels recuits peuvent être réalisés à la pression atmosphérique.

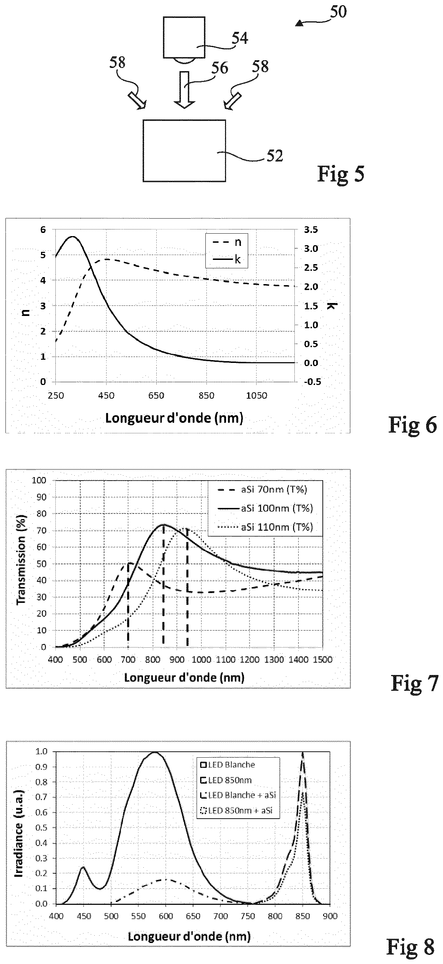

La figure 5 représente un mode de réalisation d'un système optoélectronique 50 comprenant un photodétecteur 52, correspondant à l'un des photodétecteurs 10, 30, 35, 40 décrits précédemment et une source 54 d'un rayonnement infrarouge 56. La source 52 peut correspondre à une diode électroluminescente, LED, infrarouge. A titre de variante, la source 52 peut correspondre à un point chaud. Le photodétecteur 52 peut en outre recevoir un rayonnement électromagnétique parasite 58, par exemple la lumière ambiante. Le système optoélectronique 50 est, par exemple, utilisé pour la détection d'un objet interposé entre la source infrarouge 54 et le photodétecteur infrarouge 52.

La figure 6 représente des courbes d'évolution de constantes optiques, l'indice de réfraction n en trait tireté et l'indice d'extinction k en trait continu, du silicium amorphe en fonction de la longueur d'onde.

La figure 7 représente des courbes d'évolution de la transmission, exprimée en pourcents, d'un rayonnement électromagnétique monochromatique traversant la couche 12 en fonction de la longueur d'onde du rayonnement lorsque la couche 12 est une couche de silicium amorphe déposée sur un substrat en PET pour trois épaisseurs de la couche 12. La courbe en trait tireté correspond à une épaisseur de la couche 12 de 70 nm, la courbe en trait continu correspond à une épaisseur de la couche 12 de 100 nm et la courbe en trait pointillé correspond à une épaisseur de la couche 12 de 110 nm. Comme cela apparaît sur ces courbes, le filtre optique 12 fonctionne sensiblement comme un filtre passe haut et le maximum de transmission varie en fonction de l'épaisseur de la couche 12 de silicium amorphe. En particulier, pour une épaisseur de la couche 12 de 100 nm, le maximum de transmission est obtenu pour une longueur d'onde de 850 nm. La couche 12 permet donc de filtrer une partie des longueurs d'onde de la lumière visible, entre 400 nm et 700 nm. La plupart des matériaux semiconducteurs organiques agissant comme un filtre passe-haut, le photodétecteur agit comme un filtre sélectif laissant passer une plage de fréquences qui peut être modulée en fonction de l'épaisseur de la couche 12.

La figure 8 représente des courbes d'évolution de l'irradiance, exprimée en unité arbitraire (u.a.) d'une LED fournissant de la lumière blanche (courbe en trait continu), et de l'irradiance d'une LED infrarouge fournissant un rayonnement dont l'irradiance maximale est centrée sur 850 nm (courbe à tirets longs). La figure 8 représente en outre les spectres obtenus lorsque ces rayonnements ont traversé une couche de 100 nm de silicium amorphe déposée sur un substrat de PET (courbe en traits mixtes pour la lumière blanche et courbe en trait pointillé pour le rayonnement infrarouge). Le filtre optique 12 permet de bloquer 90 % de la lumière blanche tout en laissant passer sensiblement la majorité du rayonnement infrarouge.

Dans le cas du système optoélectronique 50 représenté en figure 5, la LED infrarouge peut correspondre à la source lumineuse d'excitation 54 et la LED blanche peut correspondre à la source lumineuse du rayonnement parasite 58. La présence du filtre optique 12 permet d'augmenter le ratio entre la lumière infrarouge et la lumière blanche vue par le photodétecteur 52. Ce ratio passe de 0,23 en l'absence du filtre optique 12 à 1,12 en présence du filtre optique 12, soit un facteur d'augmentation de 5.

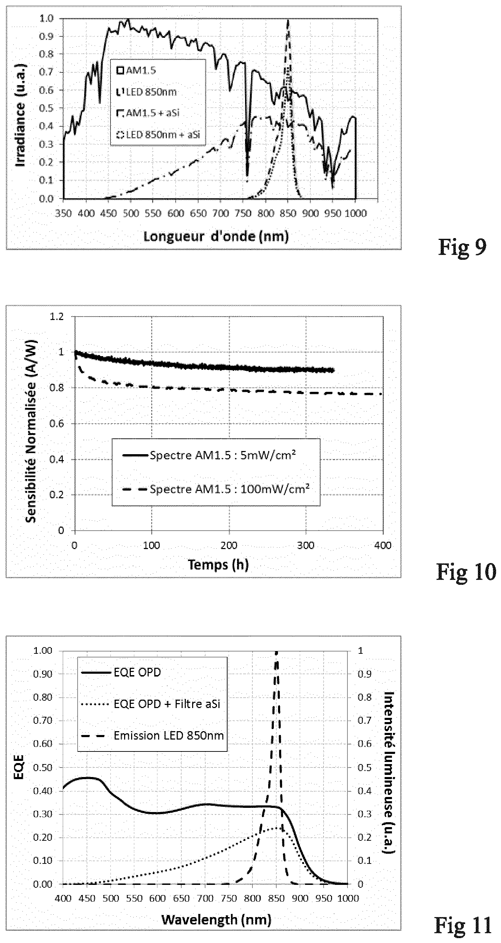

La figure 9 est une figure analogue à la figure 8 dans le cas où la lumière blanche est remplacée par la lumière du soleil dont le spectre correspond au spectre du type AM 1.5 défini par la norme ASTM G-173-03. La présence du filtre optique 12 permet d'augmenter le ratio entre la lumière infrarouge et la lumière du soleil vue par le photodétecteur 52. Ce ratio passe de 0,05 en l'absence du filtre optique 12 à 0,13 en présence du filtre optique 12, soit un facteur d'augmentation de 2,6.

De façon avantageuse, le filtre optique 12 permet d'augmenter le rapport signal sur bruit du photodétecteur organique infrarouge dans le cas où un rayonnement parasite est présent.

En outre, en jouant sur l'épaisseur de la couche 12 formant le filtre optique, la réponse spectrale du photodétecteur peut être modifiée pour s'adapter à la plage de fréquences du rayonnement infrarouge à détecter.

Le filtre optique 12 étant intégré à l'empilement de couches formant le photodétecteur et correspondant lui-même à une couche unique, l'épaisseur totale du photodétecteur peut être réduite. Un photodétecteur compact peut, de façon avantageuse, être obtenu.

De par la nature des matériaux pouvant composer la couche 12 formant le filtre optique et l'épaisseur réduite de cette couche 12, un photodétecteur flexible peut de façon avantageuse être réalisé.

Des essais ont été réalisés avec un photodétecteur test. Le photodétecteur test avait la structure du photodétecteur 10 représenté en figure 1, dans lequel la couche 12 formant le filtre optique était en silicium amorphe et avait une épaisseur de 100 nm, le substrat 14 était en PET et avait une épaisseur de 50 µm, la couche d'électrode 16 était en ITO et avait une épaisseur de 150 nm, la couche d'interface 18 était en ZnO et avait une épaisseur de 40 nm, la zone active 20 correspondait à un mélange intime à l'échelle nanométrique de PTT et de PC₆₀BM de façon à former une hétérojonction en volume et avait une épaisseur de 500 nm, la couche d'interface 22 était en PEDOT:PSS et avait une épaisseur de 700 nm, l'électrode 24 était en Ag et avait une épaisseur de 100 nm et le substrat 26 était en PET et avait une épaisseur de 50 µm.

La figure 10 représente des courbes d'évolution dans le temps de la sensibilité du photodétecteur test en l'absence de filtre optique 12 pour une densité de puissance lumineuse de 5 mW/cm² (courbe en trait continu) et une densité de puissance lumineuse de 100 mW/cm² (courbe en trait tireté). La sensibilité est proportionnelle à l'intensité du courant généré par le photodétecteur sous illumination. La sensibilité tend à diminuer en fonction du temps. Cette diminution est d'autant plus importante que la densité de puissance lumineuse est élevée. La présence du filtre optique 12 permet de réduire la dégradation de la sensibilité en bloquant une grande partie de la lumière visible.

Un essai comparatif a été réalisé avec le photodétecteur test et un photodétecteur de comparaison. Le photodétecteur de comparaison comprenait la même structure que le photodétecteur test à la différence qu'il ne comprenait pas le filtre optique 12.

La figure 11 représente une courbe d'évolution en fonction de la longueur d'onde du rayonnement incident de l'efficacité quantique externe du photodétecteur test (courbe en trait continu) et du photodétecteur de comparaison (courbe en trait pointillé) . Sur la figure 11, on a ajouté la courbe d'évolution, en trait tireté de l'intensité lumineuse, en unité arbitraire, en fonction de la longueur d'onde du rayonnement fourni par une LED infrarouge dont le spectre d'émission est maximum pour la longueur d'onde de 850 nm. La présence du filtre optique 12 permet de réduire l'efficacité quantique du photodétecteur de test par rapport au photodétecteur de comparaison dans la gamme spectrale de la lumière visible, pour une longueur d'onde de 400 nm à 700 nm.

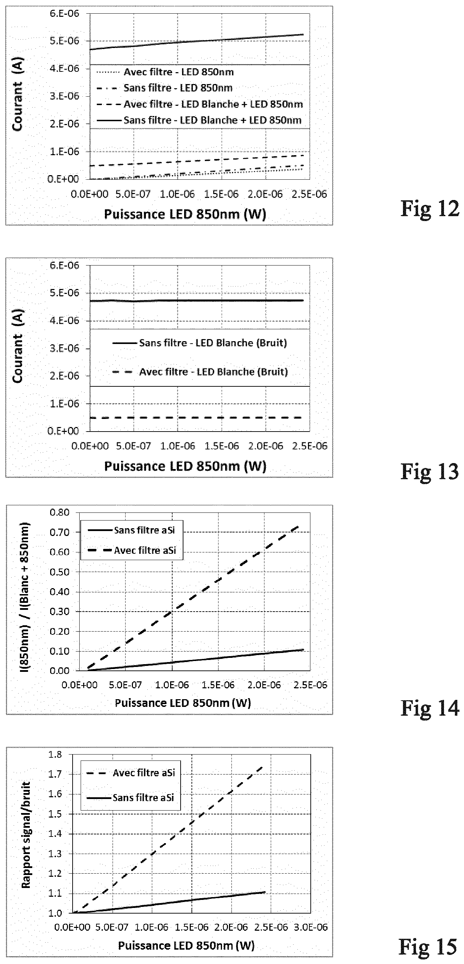

L'essai comparatif a été réalisé en éclairant le photodétecteur test et le photodétecteur de comparaison simultanément avec une LED infrarouge ayant la courbe d'irradiance représentée sur la figure 8 et ayant une puissance maximale de 300 µW/cm² et une LED blanche ayant la courbe d'irradiance représentée sur la figure 8 et ayant une puissance maximale de 60 µW/cm². Cet essai permet de simuler la détection d'un rayonnement infrarouge centré sur la longueur d'onde de 850 nm en présence d'un rayonnement parasite, celui de la LED blanche. Les figures 12 à 15 ont été obtenues suite à l'essai comparatif.

La figure 12 représente des courbes d'évolution, en fonction de la puissance de la LED infrarouge, du courant fourni par le photodétecteur test en présence seulement de la LED infrarouge (courbe en trait pointillé) et en présence de la LED infrarouge et de la LED blanche (courbe en trait mixte), et des courbes d'évolution, en fonction de la puissance de la LED infrarouge, du courant fourni par le photodétecteur de comparaison en présence seulement de la LED infrarouge (courbe en trait tireté) et en présence de la LED infrarouge et de la LED blanche (courbe en trait continu).

La figure 13 représente des courbes d'évolution, en fonction de la puissance de la LED infrarouge, de la partie du courant fourni due à la lumière blanche pour le photodétecteur test (courbe en trait tireté) et pour le photodétecteur de comparaison (courbe en trait continu).

En présence de lumière blanche, le photodétecteur de comparaison fournit davantage de courant que le photodétecteur test du fait de l'occultation partielle du rayonnement incident en présence de lumière blanche par le filtre optique 12 du photodétecteur test. En outre, le photodétecteur de comparaison fournit davantage de courant en présence de lumière blanche qu'en l'absence de lumière banche. Au contraire, pour le photodétecteur test, le courant fourni en l'absence de lumière blanche est proche du courant fourni en présence de la lumière blanche. Le photodétecteur test est donc peu sensible à la présence de la lumière blanche. Comme cela apparaît en figure 13, le bruit dû à la lumière blanche est réduit en présence du filtre optique 12.

La figure 14 représente des courbes d'évolution, en fonction de la puissance de la LED infrarouge, du ratio entre le courant fourni par le photodétecteur en présence seulement de la LED infrarouge et le courant fourni par le photodétecteur en présence de la LED infrarouge et de la LED blanche pour le photodétecteur test (courbe en trait tireté) et pour le photodétecteur de comparaison (courbe en trait continu). Un gain d'un facteur 7 sur le ratio de courants du photodétecteur test par rapport au photodétecteur de comparaison est obtenu.

La figure 15 représente une courbe d'évolution, en fonction de la puissance de la LED infrarouge, du rapport signal sur bruit fourni par le photodétecteur pour le photodétecteur test (courbe en trait tireté) et pour le photodétecteur de comparaison (courbe en trait continu). Le rapport signal sur bruit du photodétecteur test est supérieur à celui du photodétecteur de comparaison.

## Revendications

1. Photodétecteur infrarouge (10 ; 30 ; 35 ; 40) comprenant un empilement de couches (16, 18, 20, 22, 24) sur un substrat (14, 26) dont une zone active (20) en matériaux semiconducteurs organiques adaptée à convertir un rayonnement infrarouge (28) en un signal électrique et comprenant, dans ledit empilement et/ou sur le substrat, une seule couche (12) de filtrage au moins partiel de la lumière visible, dans lequel la couche de filtrage (12) comprend un matériau choisi parmi le groupe comprenant le silicium amorphe, les alliages de silicium et de germanium amorphe, les alliages de cuivre, d'indium, de gallium et de sélénium, le sulfure de cuivre, zinc et étain ou un mélange d'au moins deux de ces composés.

2. Photodétecteur selon la revendication 1, dans lequel l'épaisseur de la couche de filtrage (12) est comprise entre 50 nm et 150 nm.

3. Photodétecteur selon la revendication 1 ou 2, dans lequel le substrat (24, 26) est flexible.

4. Photodétecteur selon la revendication 3, dans lequel le substrat est choisi parmi le groupe comprenant le polyéthylène naphtalène, le polyéthylène téréphtalate, le poly(méthacrylate de méthyle), le polycarbonate, le polyétheréthercétone ou un polyimide.

5. Système optoélectronique (50) comprenant un photodétecteur infrarouge selon l'une quelconque des revendications 1 à 4 et une source d'un rayonnement infrarouge (54) .

6. Procédé de fabrication du photodétecteur selon l'une quelconque des revendications 1 à 4, comprenant la fabrication de la couche de filtrage (12) à une température inférieure à 200°C.

7. Procédé selon la revendication 6, dans lequel la couche de filtrage (12) est déposée par pulvérisation cathodique, par évaporation par faisceau d'électron en phase vapeur, par pulvérisation par faisceau d'ion, ou par évaporation thermique.

## Patentansprüche

1. Ein Infrarot-Photodetektor (10; 30; 35; 40) aufweisend einen Stapel von Schichten (16, 18, 20, 22, 24) auf einem Substrat (14, 26) mit einer aktiven Fläche (20) aus organischen Halbleitermaterialien, die geeignet sind Infrarotstrahlung (28) in ein elektrisches Signal umzuwandeln, und aufweisend in dem Stapel und/oder auf dem Substrat eine einzelne Schicht (12), die zumindest teilweise sichtbares Licht filtert, wobei die Filterschicht (12) ein Material aufweist, das aus der Gruppe ausgewählt ist, die amorphes Silizium, amorphen Silizium-Germanium-Legierungen, Kupfer-Indium-Gallium-Selen-Legierungen, Kupfer-Zink-Zinnsulfid oder eine Mischung aus mindestens zwei dieser Verbindungen aufweist.

2. Photodetektor nach Anspruch 1, wobei die Dicke der Filterschicht (12) im Bereich von 50 nm bis 150 nm liegt.

3. Photodetektor nach Anspruch 1 oder 2, wobei das Substrat (24, 26) flexibel ist.

4. Photodetektor nach Anspruch 3, wobei das Substrat ausgewählt ist aus der Gruppe aufweisend Polyethylennaphthalin, Polyethylenterephthalat, Poly(methylmethacrylat), Polycarbonat, Polyetheretherketon oder ein Polyimid.

5. Optoelektronisches System (50) mit dem Infrarot-Photodetektor nach einem der Ansprüche 1 bis 4 und einer Infrarotstrahlungsquelle (54).

6. Verfahren zur Herstellung des Photodetektors nach einem der Ansprüche 1 bis 4, bei dem die Filterschicht (12) bei einer Temperatur von weniger als 200°C hergestellt wird.

7. Verfahren nach Anspruch 6, wobei die Filterschicht (12) durch Kathodenzerstäubung, durch physikalische Dampfabscheidung mittels Elektronenstrahl, durch lonenstrahlzerstäubung oder durch thermisches Aufdampfen abgeschieden wird.

## Claims

1. An infrared photodetector (10; 30; 35; 40) comprising a stack of layers (16, 18, 20, 22, 24) on a substrate (14, 26) having an active area (20) made of organic semiconductor materials capable of converting an infrared radiation (28) into an electric signal and comprising, in said stack and/or on the substrate, a single layer (12) at least partially filtering visible light, wherein the filtering layer (12) comprises a material selected from the group comprising amorphous silicon, amorphous silicon-germanium alloys, copper-indium-gallium-selenium alloys, copper zinc tin sulphide, or a mixture of at least two of these compounds.

2. The photodetector of claim 1, wherein the thickness of the filtering layer (12) is in the range from 50 nm to 150 nm.

3. The photodetector of claim 1 or 2, wherein the substrate (24, 26) is flexible.

4. The photodetector of claim 3, wherein the substrate is selected from the group comprising polyethylene naphthalene, polyethylene terephthalate, poly(methyl methacrylate), polycarbonate, polyetheretherketone, or a polyimide

5. An optoelectronic system (50) comprising the infrared photodetector of any of claims 1 to 4 and a source of an infrared radiation (54).

6. A method of manufacturing the photodetector of any of claims 1 to 4, comprising manufacturing the filtering layer (12) at a temperature lower than 200°C.

7. The method of claim 6, wherein the filtering layer (12) is deposited by cathode sputtering, by electron beam physical vapor deposition, by ion beam sputtering, or by thermal evaporation.
